# EUROPEAN PATENT SPECIFICATION

(11) **EP 2 382 635 B1**
(45) Date of publication and mention of the grant of the patent: **03.04.2013**
(21) Application number: 09799719.1
(22) Date of filing: 22.12.2009
(51) Int. Cl.: G11C 15/04, G06F 12/10, G06F 17/30

(54) **CONTENT ASSEMBLY MEMORY AND METHOD**
INHALTSZUSAMMENSTELLUNGSSPEICHER UND VERFAHREN
MÉMOIRE ET PROCÉDÉ D'ASSEMBLAGE DE CONTENU

(30) Priority: 30.12.2008 US 346328
(43) Date of publication of application: 02.11.2011
(73) Proprietor: Telefonaktiebolaget L M Ericsson (PUBL), 164 83 Stockholm (SE)
(72) Inventor: HORNER, Jeremy, Nottingham, MD 21236 (US)
(74) Representative: HOFFMANN EITLE
(86) International application number: PCT/IB2009/007861
(87) International publication number: WO 2010/076628

(56) References cited:
- US-A- 4 831 586
- US-A1- 2004 030 803

## Description

### TECHNICAL FIELD

The present invention is related to a content addressable memory (CAM) having a programmable key update mechanism which updates keys without the keys leaving the CAM. (As used herein, references to the "present invention" or "invention" relate to exemplary embodiments and not necessarily to every embodiment encompassed by the appended claims.) More specifically, the present invention is related to a content addressable memory (CAM) having a programmable key update mechanism which updates keys without the keys leaving the CAM where the key update mechanism includes a configurable logic block that includes FPGA-logic.

### BACKGROUND

This section is intended to introduce the reader to various aspects of the art that may be related to various aspects of the present invention. The following discussion is intended to provide information to facilitate a better understanding of the present invention. Accordingly, it should be understood that statements in the following discussion are to be read in this light, and not as admissions of prior art.

This invention is related to the invention disclosed in US2009323529. That invention focused on using an associative array to improve network traffic schedulers. This invention focuses on how to create a new novel type of associative array which would allow a scheduler such as that described in US2009 323529 to be improved upon even further. The invention described here would have potential applications beyond schedulers, but the example of an ATM cell scheduler will be used to illustrate the merit of this invention. It should also be noted that this invention refers to a Content Addressable Memory (CAM) which is a hardware implementation of an associative array.

Content Addressable Memory (CAM) is often used in network devices to search a table of relatively static network addresses at a very high rate of speed. For example, MAC addresses and IP addresses are often stored in a CAM; when a packet arrives, a search of the CAM using the destination address as the search key will result in the next-hop for the packet. These MAC and IP addresses can change, but do not change very often. CAMs are designed with this type of application in mind. They provide a mechanism to update the stored keys, but the updates take a long time to complete. Instead, CAMs are designed to achieve the maximum search performance.

In CAM related art, US Patent No. 4,831,586 discloses a CAM that has priority ranking circuit or a write control circuit that is provided in an output section. The priority ranking circuit is adapted to be operated to selectively output only one hit signal and the write control circuit receives a high signal and allows a corresponding memory cell to be brought into a write enable state.

Content Addressable Memory is often used in network switching or routing applications. The following describes a generic procedure to prepare a CAM for searches and to search for and update an entry in the CAM. (Note: This does not include the basic initialization steps that the CAM requires when first powered up.)
1. For each entry that should be searchable, the FPGA (or other interfacing device) must perform a write operation to the CAM.
   a. This write operation specifies the address to store the data word and the data word itself. By doing this it also "validates" the entry which tells the CAM to include that entry in any searches that are initiated in the future.
   b. A ternary CAM (which provides for wildcard searches) also allows a mask to be stored with each data word. This allows the entry to match values that are searched for even if it's not an exact match for the data word. For example, if the entry at address 0x0 stored the data word 00011??0 (where ? represents a don't care stored in the mask), then a search for 00011010 will match the entry as will any search value which matches bits 0, 3, 4, 5, 6 and 7. Bits 1 and 2 do not have to match.
   c. Searches in a ternary CAM can also take advantage of one of many Global Mask Registers. These turn a normal search into a wildcard search. Here's an example: If the stored data and mask require a complete match to the data value 00011000, we could search for the value 00011001 and use a Global Mask Register which masks off the least significant bit from the search value turning the search into a wildcard search with the value 0001100?. This wildcard search would then match the stored entry.
2. The FPGA then initiates a search of the CAM using a search key. The FPGA does not know where the data is stored in the CAM, but it does know the data it is looking for. The FPGA would provide the data word (a 72-bit value, for example) along with an optional Global Mask Register for wildcard searches.
3. Upon receiving the search request from the FPGA, the CAM searches all of its stored entries (which are valid) and returns the address of each match. If there are no matches (referred to as hits) for a given search, then the CAM tells the FPGA that no hits were found. If multiple hits occur, then the FPGA can read all of them out sequentially.
4. The address returned by the CAM for the search is usually used to point to additional data that is stored in another "normal" RAM. The FPGA accesses this information by using address returned from the CAM as the address to lookup the data word(s) in the RAM.
5. If the FPGA needs to update the CAM entries, it must calculate the new data word to be programmed into the CAM. If the entry in the CAM does not require updating, then the process ends here.
6. If the CAM entry needs to be updated, but the FPGA does not know where the CAM entry is stored, the FPGA can do a search and invalidate operation. Like the search operation, the FPGA provides the data, but instead of returning the address, the CAM invalidates that entry. If the FPGA already knows the address of the CAM entry, then this invalidate step can be skipped.
7. Finally, the FPGA needs to write the updated value to the CAM so that it can be included in future searches. (Note: If the new entry is written to the same address of the entry being replaced, then it is not necessary to invalidate the old entry).

The key difference between CAM (Content Addressable Memory) and RAM (Random Access Memory) which covers almost all memory storage devices is that RAM uses a user supplied memory address to locate and retrieve the data word stored at that address. For a CAM, the user supplies the data word, and the CAM returns the storage addresses which point to the location of the data that actually resides in a separate RAM device. This allows one to store a large amount of data in RAM and use the CAM along with the data word to help you locate find it. With a RAM, you already have to know where the data is located.

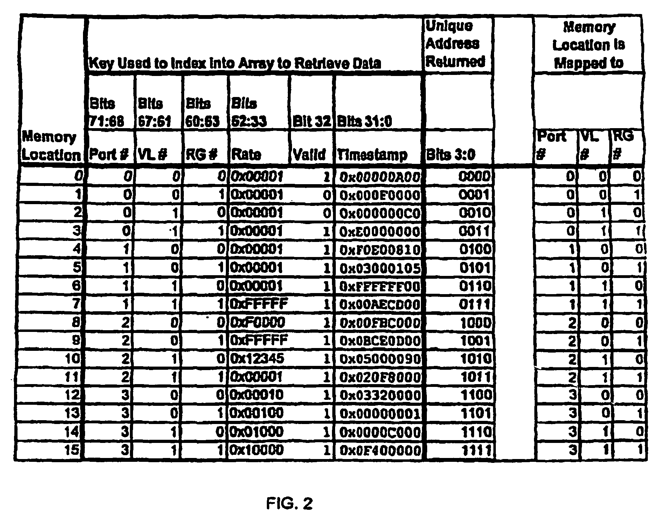

Figure 2 shows an example of an associative array used for timestamp storage for a 4-port scheduler with 2 VLs per port and 2 RGs per VL. For this example, assume that the present time, which is tracked by the scheduler's internal time counter, has the value 0x00000001 and that the scheduler must locate the RG that is eligible to schedule during that time slot for Port 3. The scheduler would follow these steps:
1. The scheduler would initiate a search of the associative array with the following search key:

| **Bits 71:68** | **Bits 67:50** | **Bits 49:33** | **Bit 32** | **Bits 31:0** |
|---|---|---|---|---|
| **Port #** | **VL#** | **RG#** | **Valid** | **Timestamp** |
| 3 | don't care | don't care | 1 | 0x00000001 |

2. The associative array would return the binary value 1101 which would map to Port 3, VL 0, and RG 1. This RG is eligible to be scheduled during the current time slot.
3. Read programmed transmission rate from RG's configuration memory.
4. Calculate a new timestamp (using the old timestamp, programmed rate, and, ATM cell size) indicating the time the RG will be eligible to schedule.
5. Write updated timestamp to the associative array replacing the old timestamp.

Although CAMs work very well for their typical application of searching a relatively static table of keys, CAMs could be further optimized for use with a dynamic table of keys.

In particular, if the update to the keys is predictable and can be expressed using data that already exists in the CAM or can be provided to it along with a search operation, then the update can happen automatically in the CAM. In the example of the ATM scheduler with a timestamp associative array, steps 3, 4, and 5 would be optimized out.

Optimizing a CAM to include support for tables of dynamic keys allows the CAM to benefit a broader range of applications.

US 2004/0030803 A1 discloses methods and apparatus are disclosed for performing lookup operations using associative memories, including, but not limited to modifying search keys within an associative memory based on modification mappings, forcing a no-hit condition in response to a highest-priority matching entry including a force no-hit indication, selecting among various sets or banks of associative memory entries in determining a lookup result, and detecting and propagating error conditions. In one implementation, each block retrieves a modification mapping from a local memory and modifies a received search key based on the mapping and received modification data. In one implementation, each of the associative memory entries includes a field for indicating that a successful match on the entry should or should not force a no-hit result. In one implementation, an indication of which associative memory blocks or sets of entries to use in a particular lookup operation is retrieved from a memory.

### SUMMARY

According to a first aspect of the invention there is provided a content addressable memory, CAM, as set out in Claim 1.

According to a second aspect of the invention there is provided a method for using a content addressable memory, CAM, as set out in Claim 8.

### BRIEF DESCRIPTION OF THE DRAWINGS

In the accompanying drawings, the preferred embodiment of the invention and preferred methods of practicing the invention are illustrated in which:

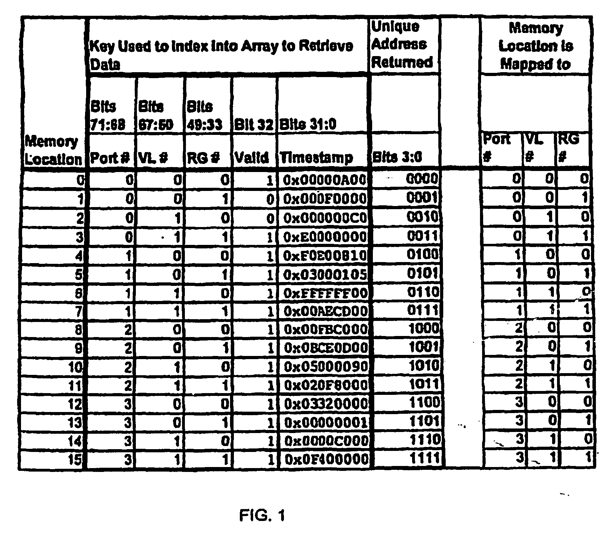

FIG. 1-Example Associative Array Timestamp Storage (4-ports, 2-VLs/Port, 2-RGs/VL).
FIG. 2-Example Associative Array Timestamp Storage (4-ports, 2-VLs/Port, 2-RGs/VL).
FIG. 3 is a block diagram of a CAM of the present invention.

### DETAILED DESCRIPTION

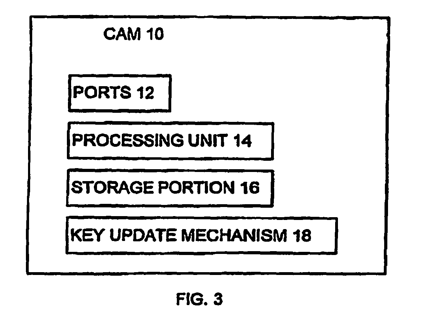

Referring now to the drawings wherein like reference numerals refer to similar or identical parts throughout the several views, and more specifically to FIG. 3 thereof, there is shown a content addressable memory 10 (CAM). The CAM 10 comprises ports 12 through which keys having at least a 16 bit function and preferably at least a 72 bit function are received or transmitted. The CAM 10 comprises a processing unit 14 in communication with the ports 12. The CAM 10 comprises a storage portion 16 in which the keys are stored in communication with a processing unit 14. The CAM 10 comprises a programmable key update mechanism 18 in communication with the processing unit 14 which updates the keys without the keys leaving the CAM 10.

Preferably, the key update mechanism 18 automatically invalidates an old key. The key update mechanism 18 preferably automatically creates a new key. Preferably, the key update mechanism 18 automatically writes the new key to a same address in the storage portion 16 as the old key. The key update mechanism 18 preferably creates the new key by using a pre-programmed update function that accepts as inputs the old key, and one or more fields included in a search and update instruction. Preferably, the key update mechanism includes a configurable logic block. The configurable logic block preferably includes FPGA-logic. Preferably, the key update mechanism 18 is disabled for use with static keys.

The present invention pertains to a method for using a content addressable memory 10 (CAM). The method comprises the steps of receiving keys having at least a 16 bit function at a port and preferably at least a 72 bit function at a port. There is the step of storing the keys in a storage portion 16 in communication with a processing unit 14. There is the step of updating the keys without the keys leaving the CAM 10 with a programmable key update mechanism 18 in communication with a processing unit 14.

Preferably, there is the step of automatically invalidating an old key with the key update mechanism 18. There is preferably the step of automatically creating a new key with the key update mechanism 18. Preferably, there is the step of automatically writing the new key to a same address in the storage portion 16 as the old key with the key update mechanism 18. There is preferably the step of creating the new key with the key update mechanism 18 by using a pre-programmed update function that accepts as inputs the old key, and one or more fields included in a search and update instruction. Preferably, the key upgrade mechanism includes a configurable logic block. The configurable logic block preferably includes FPGA-logic. There is preferably the step of disabling the key update mechanism 18 for use with static keys.

In the operation of the invention, a CAM 10 can be enhanced to support dynamic keys by integrating an automatic key update mechanism 18 into a new "search and update" instruction. This mechanism would include the following features:
- Automatic invalidation of the old key
- Automatic creation of a new key. This new key would be formed by using a pre-programmed update function that would accept as inputs the old key, and one or more fields included in the "search and update" instruction.
- Automatic writing of new key to the same address as the old key for future searches.

This invention would incorporate a new logic block into a CAM 10 in order to provide a mechanism for changing the data stored in the CAM 10 automatically, given that the required update can be described as a function of the old key (or a portion of it), and data field(s) provided by the interfacing logic during the "search and update" instruction.

A traffic scheduler will be used to illustrate the benefit provided by this invention. If the CAM 10 or an associative array is used to store the timestamps for a traffic scheduler (as outlined in US2009 323529), the new timestamp can be described as a function of the old timestamp, the programmed bandwidth, and the size of the packet or cell that was just scheduled.

The following is a description of how a CAM 10 designed for dynamic keys would be used.
1. The pre-defined CAM 10 update function(s) must be defined. These need to be defined as a function of the original CAM 10 entry and fields which will be provided when the "search and update" operation is performed.
2. For each entry that should be searchable, the FPGA (or other interfacing device) must perform a write operation to the CAM 10.
   a. This write operation specifies the address to store the data word and the data word itself. By doing this it also "validates" the entry which tells the CAM 10 to include that entry in any searches that are initiated in the future.
   b. A ternary CAM 10 (which provides for wildcard searches) also allows a mask to be stored with each data word. This allows the entry match values that are searched for even if it's not an exact match for the data word. For example, if the entry at address 0x0 stored the data word 00011??0 (where ? represents a don't care stored in the mask), then a search for 00011010 will match the entry as will any search value which matches bits 0, 3, 4, 5, 6 and 7. Bits 1 and 2 do not have to match.
   c. Searches in a ternary CAM 10 can also take advantage of one of many Global Mask Registers. These turn a normal search into a wildcard search. Here's an example: If the stored data and mask require a complete match to the data value 00011000, we could search for the value 00011001 and use a Global Mask Register which masks off the least significant bit from the search value turning the search into a wildcard search with the value 0001100?. This wildcard search would then match the stored entry.
3. The FPGA then initiates a "search and update" operation of the CAM 10 using a search key and the selected pre-defined update function that is to be used for any entries that match the search. The FPGA does not know where the data is stored in the CAM 10, but it does know the data it is looking for. The FPGA would provide the data word (a 72-bit value, for example) along with an optional Global Mask Register for wildcard searches.
4. Upon receiving the search request from the FPGA, the CAM 10 searches all of its stored entries (which are valid) and returns the address of each match. If there are no matches (referred to as hits) for a given search, then the CAM 10 tells the FPGA that no hits were found. If multiple hits occur, then the FPGA can read all of them out sequentially.
5. The address returned by the CAM 10 for the search is often used to point to additional data that is stored in another "normal" RAM. The FPGA accesses this information by using address returned from the CAM 10 as the address to lookup the data word(s) in the RAM.
6. If the FPGA needs to update the CAM 10 entries, it must calculate the new data word to be programmed into the CAM 10. If the entry in the CAM 10 does not require updating, then the process ends here.
7. If the CAM 10 entry needs to be updated, but the FPGA does not know where the CAM 10 entry is stored, the FPGA can do a search and invalidate operation. Like the search operation, the FPGA provides the data, but instead of returning the address, the CAM 10 invalidates that entry. If the FPGA already knows the address of the CAM 10 entry, then this invalidate step can be skipped.
8. Finally, the FPGA needs to write the updated value to the CAM 10 so that it can be included in future searches. (Note: If the new entry is written to the same address of the entry being replaced, then it is not necessary to invalidate the old entry).

Figure 2 shows an example of an associative array used for timestamp storage for a 4-port scheduler with 2 VLs per port and 2 RGs per VL. For this example, assume that the present time, which is tracked by the scheduler's internal time counter, has the value 0x00000001 and that the scheduler must locate the RG that is eligible to schedule during that time slot for Port 3. The scheduler would follow these steps:
1. The scheduler would initiate a search in the associative array with the following search key:

| **Bits 87:72** | **Bits 71:68** | **Bits 67:61** | **Bits 60:53** | **Bits 52:33** | **Bit 32** | **Bits 31:0** |
|---|---|---|---|---|---|---|
| **Update Field (cell/pack et size)** | **Port #** | **VL#** | **RG#** | **Rate** | **Valid** | **Timestamp** |
| 54 | 3 | don't care | don't care | don't care | 1 | 0x00000001 |

2. The associative array would return the binary value 1101 which would map to Port 3, VL 0, and RG 1. This RG would therefore be eligible for scheduling during the current time slot.
3. The associative array would then automatically calculate a new timestamp for this Port/VL/RG combination using the old timestamp, programmed rate, and cell size (which could be provided in the "search and update" instruction or could be hard-coded into the update function). It would then write the updated timestamp to the location of the old entry in preparation for the next search.

The programmable update mechanism could be implemented in a number of ways, but the most flexible way would be to embed a fully configurable logic block of an appropriate size which would resemble the flexibility and capability provided by FPGA-logic. (Note: Some FPGA vendors allow an engineer to instantiate a standard CAM 10 using FPGA-logic. Adding an auto-update mechanism using programmable FPGA-logic cells would be particularly straightforward in this case.) IDT Corporation and Alera Corporation are two companies that produce generic CAMS 10 from which this invention can be based.

It may be desirable to include more than one update unit to allow for a single associative array to be used simultaneously for multiple options for dynamically updating keys. Alternatively, having multiple update units could allow the updates to be pipelined. Doing this would allow the update function to be defined to use update fields from subsequent "search and update" instructions. This may be essential if used with a packet scheduler where the packet length may not be known until the RG is chosen by the scheduler.

It may be desirable for the associative array to have a mode where the update mechanism can be disabled for use with static keys. This would be particularly useful if the update mechanism negatively affects performance for static keys.

By providing a mechanism to automatically update the timestamp entries in-place rather than external to the CAM 10, the key updates can occur more rapidly and with significantly fewer instructions issued by the controlling logic.

The result of this invention would be a higher performance associative array when used for dynamic keys. A traffic scheduler using this invention would be capable of scheduling at a higher rate without sacrificing other scheduler features.

### Abbreviations

CAM = Content Addressable Memory.
RAM = Random Access Memory
RG = Rate Group
Ternary CAM = This is a type of CAM that allows for 3 states to be stored for each bit: 1, 0, and '?' (don't care). This type of CAM also provides the capability to do wild card searches using Global Mask Registers.
VL = Virtual Link

Although the invention has been described in detail in the foregoing embodiments for the purpose of illustration, it is to be understood that such detail is solely for that purpose and that variations can be made therein by those skilled in the art without departing from the scope of the invention except as it may be described by the following claims.

## Claims

1. A content addressable memory, CAM, (10) comprising:
ports (12) through which keys having at least a 16 bit function are received or transmitted;
a processing unit (14) in communication with the ports;
a storage portion (16) in which the keys are stored in communication with a processing unit; and
a programmable key update mechanism (18) in communication with the processing unit which updates the keys without the keys first being read from the CAM, the key update mechanism creating a new key by using a pre-programmed update function that accepts as inputs an old key, and one or more fields included in a search and update instruction.

2. The CAM as described in claim 1 wherein the key update mechanism automatically invalidates an old key.

3. The CAM as described in claim 1 wherein the key update mechanism automatically creates a new key.

4. The CAM as described in claim 3 wherein the key update mechanism automatically writes the new key to a same address in the storage portion as the old key.

5. The CAM as described in claim 1 wherein the key update mechanism includes a configurable logic block.

6. The CAM as described in claim 5 wherein the configurable logic block includes FPGA -- logic.

7. The CAM as described in claim 1 wherein the key update mechanism is disabled for use with static keys.

8. A method for using a content addressable memory, CAM, (10) comprising the steps of:
receiving keys having at least a 16 bit function at a port (12);
storing the keys in a storage portion (16) in communication with a processing unit; and
updating the keys without the keys first being read from the CAM, with a programmable key update mechanism (18) in communication with a processing unit (14) the key update mechanism creating a new key by using a pre-programmed update function that accepts as inputs an old key, and one or more fields included in a search and update instruction.

9. The method as described in claim 8 including the step of automatically invalidating the old key with the key update mechanism.

10. The method as described in claim 8 including the step of automatically creating a new key with the key update mechanism.

11. The method as described in claim 8 including the step of automatically writing the new key to a same address in the storage portion as the old key with the key update mechanism.

12. The method as described in claim 8 wherein the key update mechanism includes a configurable logic block.

13. The method as described in claim 12 wherein the configurable logic block includes FPGA -- logic.

14. The method as described in claim 8 including the step of disabling the key update mechanism for use with static keys.

## Patentansprüche

1. Inhaltsadressierbarer Speicher, CAM, (10) umfassend:
Anschlüsse (12) durch welche Schlüssel mit wenigsten einer 16-Bit-Funktion empfangen oder übertragen werden;
eine Verarbeitungseinheit (14) in Kommunikation mit den Anschlüssen;
einen Speicherabschnitt (16), in welchen die Schlüssel gespeichert werden, in Kommunikation mit einer Verarbeitungseinheit; und
einen programmierbaren Schlüsselaktualisierungsmechanismus (18) in Kommunikation mit der Verarbeitungseinheit, welcher die Schlüssel aktualisiert, ohne dass die Schlüssel erst aus dem CAM gelesen werden, wobei der Schlüsselaktualisierungsmechanismus einen neuen Schlüssel erzeugt, indem eine vorprogrammierte Aktualisierungsfunktion verwendet wird, die als Eingaben einen alten Schlüssel akzeptiert, und ein oder mehr Felder, enthalten in einer Such- und Aktualisierungsinstruktion.

2. CAM nach Anspruch 1, wobei der Schlüsselaktualisierungsmechanismus automatisch einen alten Schlüssel ungültig macht.

3. CAM nach Anspruch 1, wobei der Schlüsselaktualisierungsmechanismus automatisch einen neuen Schlüssel erzeugt.

4. CAM nach Anspruch 3, wobei der Schlüsselaktualisierungsmechanismus automatisch den neuen Schlüssel an eine selbe Adresse in dem Speicherabschnitt wie den alten Schlüssel schreibt.

5. CAM nach Anspruch 1, wobei der Schlüsselaktualisierungsmechanismus einen konfigurierbaren Logikblock umfasst.

6. CAM nach Anspruch 5, wobei der konfigurierbare Logikblock FPGA-Logik umfasst.

7. CAM nach Anspruch 1, wobei der Schlüsselaktualisierungsmechanismus zur Nutzung mit statischen Schlüsseln deaktiviert wird.

8. Verfahren zur Verwendung eines inhaltadressierbaren Speichers, CAM, (10), umfassend die Schritte Empfangen von Schlüsseln mit wenigstens einer 16-Bit-Funktion an einem Anschluss (12);
Speichern der Schlüssel in einem Speicherabschnitt (16) in Kommunikation mit einer Verarbeitungseinheit; und
Aktualisieren der Schlüssel ohne dass die Schlüssel erst aus dem CAM ausgelesen werden mit einem programmierbaren Schlüsselaktualisierungsmechanismus (18) in Kommunikation mit einer Verarbeitungseinheit (14), wobei der Schlüsselaktualisierungsmechanismus einen neuen Schlüssel erzeugt, indem eine vorprogrammierte Aktualisierungsfunktion verwendet wird, die als Eingaben einen alten Schlüssel akzeptiert, und ein oder mehr Felder, enthalten in einer Such- und Aktualisierungsinstruktion.

9. Verfahren nach Anspruch 8, umfassend den Schritt eines automatischen ungültig-Machens des alten Schlüssels mit dem Schlüsselaktualisierungsmechanismus.

10. Verfahren nach Anspruch 8, umfassend den Schritt eines automatischen Erzeugens eines neuen Schlüssels mit dem Schlüsselaktualisierungsmechanismus.

11. Verfahren nach Anspruch 8, umfassend den Schritt eines automatischen Schreibens des neuen Schlüssels an eine selbe Adresse in dem Speicherabschnitt wie der alte Schlüssel mit dem Schlüsselaktualisierungsmechanismus.

12. Verfahren nach Anspruch 8, wobei der Schlüsselaktualisierungsmechanismus einen konfigurierbaren Logikblock umfasst.

13. Verfahren nach Anspruch 12, wobei der konfigurierbare Logikblock FPGA-Logik umfasst.

14. Verfahren nach Anspruch 8, umfassend den Schritt eines Deaktivierens des Schlüsselaktualisierungsmechanismus zur Verwendung mit statischen Schlüsseln.

## Revendications

1. Mémoire adressable par le contenu (10), comprenant :
des ports (12) sur lesquels des clefs possédant au moins une fonction sur 16 bits sont reçues ou émises ;
une unité de traitement (14) en communication avec les ports ;
une partie de stockage (16) dans laquelle les clefs sont stockées en communication avec une unité de traitement ; et
un mécanisme de mise à jour de clef programmable (18) en communication avec l'unité de traitement, qui met à jour les clefs sans que celles-ci soient d'abord lues dans la mémoire adressable par le contenu, le mécanisme de mise à jour des clefs créant une nouvelle clef en utilisant une fonction de mise à jour préprogrammée qui accepte en entrée une vieille clef, et un ou plusieurs champs contenus dans une instruction de recherche et de mise à jour.

2. Mémoire adressable par le contenu selon la revendication 1, dans laquelle le mécanisme de mise à jour de clef invalide automatiquement une vieille clef.

3. Mémoire adressable par le contenu selon la revendication 1, dans laquelle le mécanisme de mise à jour de clef crée automatiquement une nouvelle clef.

4. Mémoire adressable par le contenu selon la revendication 3, dans laquelle le mécanisme de mise à jour de clef écrit automatiquement la nouvelle clef dans la partie de stockage à la même adresse que la vieille clef.

5. Mémoire adressable par le contenu selon la revendication 1, dans laquelle le mécanisme de mise à jour de clef comprend un bloc logique configurable.

6. Mémoire adressable par le contenu selon la revendication 5, dans laquelle le bloc logique configurable comprend une logique de FPGA.

7. Mémoire adressable par le contenu selon la revendication 1, dans laquelle le mécanisme de mise à jour de clef est inhibé dans le cas de clefs statiques.

8. Procédé d'utilisation d'une mémoire adressable par le contenu (10), comprenant les étapes consistant à :
recevoir sur un port (12) des clefs possédant au moins une fonction sur 16 bits ;
stocker les clefs dans une partie de stockage (16) en communication avec une unité de traitement ; et
mettre à jour les clefs sans que celles-ci soient d'abord lues dans la mémoire adressable par le contenu, avec un mécanisme de mise à jour de clef programmable (18) en communication avec une unité de traitement (14), le mécanisme de mise à jour de clef créant une nouvelle clef en utilisant une fonction de mise à jour préprogrammée qui accepte en entrée une vieille clef, et un ou plusieurs champs contenus dans une instruction de recherche et de mise à jour.

9. Procédé selon la revendication 8, comprenant l'étape consistant à automatiquement invalider la vieille clef à l'aide du mécanisme de mise à jour de clef.

10. Procédé selon la revendication 8, comprenant l'étape consistant à automatiquement créer une nouvelle clef à l'aide du mécanisme de mise à jour de clef.

11. Procédé selon la revendication 8, comprenant l'étape consistant à automatiquement écrire la nouvelle clef dans la partie de stockage à la même adresse que la vieille clef, à l'aide du mécanisme de mise à jour de clef.

12. Procédé selon la revendication 8, dans lequel le mécanisme de mise à jour de clef comprend un bloc logique configurable.

13. Procédé selon la revendication 12, dans laquelle le bloc logique configurable comprend une logique de FPGA.

14. Procédé selon la revendication 8, comprenant l'étape consistant à inhiber le mécanisme de mise à jour de clef dans le cas de clefs statiques.
